# EUROPEAN PATENT APPLICATION

(11) **EP 2 096 707 A1**
(43) Date of publication of application: **02.09.2009**
(21) Application number: 09250146.9
(22) Date of filing: 20.01.2009
(51) Int. Cl.: H01Q 1/24, H01Q 1/40

(54) **Housing, wireless communication device using the housing, and manufacturing method thereof**

(30) Priority: 26.02.2008 CN 200810300399
(71) Applicant: Shenzhen Futaihong Precision Industry Co., Ltd., Shenzhen City, Guangdong Province 518109 (CN); FIH (Hong Kong) Limited, Hong Kong (HK)
(72) Inventor: Yang, Fu-Keng, Shindian City, Taipei Hsien Taiwan 231 (CN); Zhang, Bing, ShenZhen City, Guangdong Province 518109 (CN); Zeng, Yi-Ping, ShenZhen City, Guangdong Province 518109 (CN); Zhan, Jian-Jun, ShenZhen City, Guangdong Province 518109 (CN)
(74) Representative: Craven, Ian

(57) **Abstract**

A housing for a wireless communication device includes a substrate (131) and an antenna pattern (133) formed on the substrate. The antenna pattern is an electroplated metal coating.

## Description

The present disclosure relates to wireless communication devices, and particularly to a device housing having a conductive track for sending and receiving electromagnetic waves.

Antennas sending or receiving electromagnetic waves are basic units used in mobile communication devices. With increasing demand for reduced device profile, antennas are frequently incorporated into housings of such devices.

The antennas incorporated in the housings are usually copper or silver sheets formed in a patterned conductive track. A frequent method of manufacturing such housings includes attaching a patterned copper or silver sheet to a laminate using adhesive, in which the laminate may be a plastic film used in an insert molding process. The laminate is mounted into an injection mold, and a melted resin is injected into the injection mold and molded thereon to form a molded housing. The resulting patterned copper or silver sheet can function as an antenna when the molded housing is used in a mobile communication device. However, the patterned copper or silver sheet typically has a thickness exceeding 0.3 millimeters (mm), increasing the thickness and size of the molded housing.

Therefore, there is room for improvement within the art.

### BRIEF DESCRIPTION OF THE DRAWINGS

Many aspects of the housing for a wireless communication device can be better understood with reference to the following drawings. The components in the drawings are not necessarily drawn to scale, the emphasis instead being placed upon clearly illustrating the principles of the molded article. Moreover, in the drawings like reference numerals designate corresponding parts throughout the several views.

FIG. 1 is a schematic view of a wireless communication device.

FIG. 2 is an exploded view of the wireless communication device as shown in FIG. 1.

### DETAILED DESCRIPTION OF THE DISCLOSURE

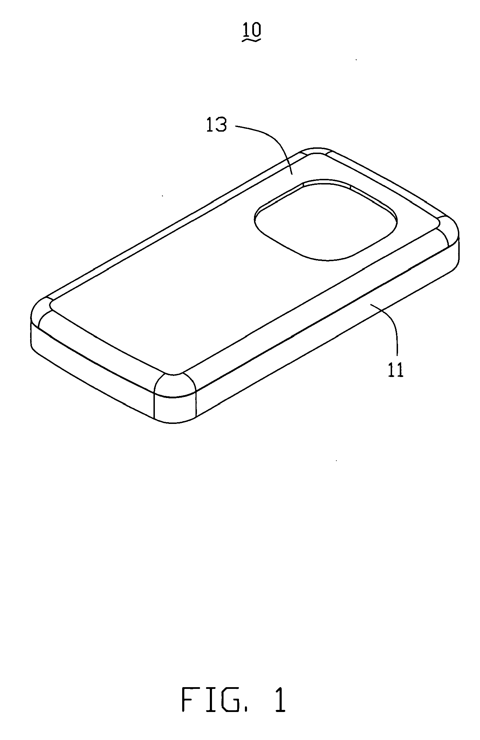

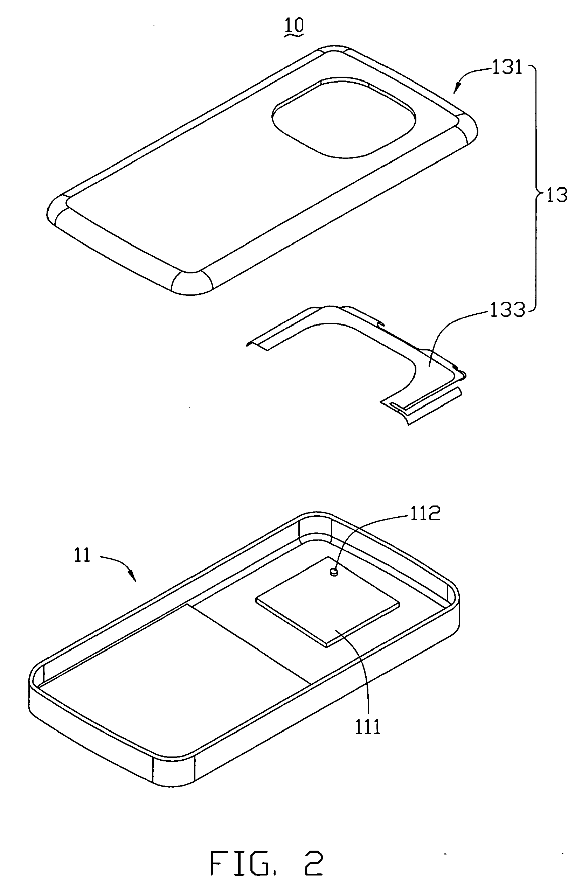

Referring to FIG. 1 and FIG. 2, the disclosed wireless communication device 10, here a mobile phone, includes a main body 11 and the disclosed housing 13 mounted on the main body 11.

The main body 11 includes a printed circuit board 111 installed therein. The printed circuit board 111 has a flexible conductive pole 112 configured for sending and/or receiving electromagnetic waves.

The housing 13 includes a substrate 131 and an antenna pattern 1 33 formed on the substrate 131.

The substrate 131 may be acrylonitrile-butadiene-styrene, polycarbonate, or a mixture of acrylonitrile-butadiene-styrene and polycarbonate. Further, the substrate 131 can alternatively be silicone or glass.

The antenna pattern 1 33 is a metal coating of copper or silver. In this embodiment the antenna pattern 133 is C-shaped and manufactured via physical vacuum deposition, but may have other shapes in other embodiments according to need. The antenna pattern 132 is from 0.002mm to 0.015mm.

The housing 13 is integrally mounted on the main body 11. The protective coating 134 is defined at a side of the substrate 131 facing the printed circuit board 111. The conductive pole 112 of the printed circuit board 111 is near the antenna circuit pattern 133. The gap between the conductive pole 112 and the antenna circuit pattern 133 is less than 0.5mm.

During the disclosed method of manufacturing the housing 13, a substrate of plastic, silica gel, or glass is provided. One surface of the substrate is then plasma activated in a plasma of nitrogen gas, oxygen gas, or hydrogen gas. The activated surface of the substrate is coated with a metal coating of copper or silver to form the antenna pattern 1 33 via vacuum deposition. As such, the housing 13 with an antenna integrated therein is obtained.

The antenna circuit pattern 133 obtained by the disclosed process may be thinner than a currently used metal sheet antenna, thereby benefiting the reduction in profile and size of the wireless communication device 10, and provides a simplified manufacturing process as well.

It should be also understood, however, that even though numerous characteristics and advantages of the present embodiments have been set forth in the foregoing description, together with details of the structures and functions of the embodiments, the disclosure is illustrative only, and changes may be made in detail, especially in matters of shape, size, and arrangement of parts within the principles of the disclosure to the full extent indicated by the broad general meaning of the terms in which the appended claims are expressed.

## Claims

1. A housing for a wireless communication device, comprising:
a substrate; and
an antenna circuit pattern disposed on the substrate;
wherein the antenna circuit pattern is a vacuum deposited metal coating.

2. The housing as claimed in claim 1, wherein the substrate is acrylonitrile-butadiene-styrene, polycarbonate, or a mixture of acrylonitrile-butadiene-styrene and polycarbonate.

3. The housing as claimed in claim 1, wherein the substrate is silica gel or glass.

4. The housing as claimed in claim 1, wherein the antenna pattern is 0.002mm to 0.01 5mm thick.

5. A wireless communication device, comprising:
a main body comprising a printed circuit board therein, the printed circuit board comprising a conductive pole mounted thereon configured for sending and/or receiving electromagnetic waves; and
a housing mounted on the main body, comprising:
a substrate; and
an antenna circuit pattern disposed on the substrate;
wherein the antenna circuit pattern is a vacuum deposited metal coating.

6. The wireless communication device as claimed in claim 5, wherein the substrate is acrylonitrile-butadiene-styrene, polycarbonate, or a mixture of acrylonitrile-butadiene-styrene and polycarbonate.

7. The wireless communication device as claimed in claim 5, wherein the substrate is silica gel or glass.

8. The wireless communication device as claimed in claim 5, wherein the gap between the conductive pole and the antenna pattern is less than 0.5mm.

9. The wireless communication device as claimed in claim 5, wherein the antenna pattern is from 0.002mm to 0.015mm thick..

10. A method for manufacturing a housing for a wireless communication, comprising:
providing a substrate;
activating the substrate in a plasma of one of nitrogen gas, oxygen gas and hydrogen gas; and
vacuum depositing a metal coating onto the substrate to form an antenna pattern.

11. The method as claimed in claim 10, wherein the substrate is acrylonitrile-butadiene-styrene, polycarbonate, or a mixture of acrylonitrile-butadiene-styrene and polycarbonate.

12. The method as claimed in claim 10, wherein the substrate is silica gel or glass.

13. The method as claimed in claim 10, wherein a thickness of the antenna pattern is from 0.002mm to 0.01 5mm.
